# EUROPÄISCHE PATENTANMELDUNG

(11) **EP 4 723 417 A1**
(43) Veröffentlichungstag der Anmeldung: **08.04.2026**
(21) Anmeldenummer: 24203821.4
(22) Anmeldetag: 01.10.2024
(51) Int. Cl.: H02J 3/00, H02J 13/00

(54) **VERFAHREN FÜR EINE ERKENNUNG VON FEHLERHAFTEN MESSWERTEN, FEHLERERKENNUNGSANORDNUNG UND COMPUTERPROGRAMMPRODUKT**

(71) Anmelder: Siemens Aktiengesellschaft, 80333 München (DE)
(72) Erfinder: Henselmeyer, Sylwia, 91052 Erlangen (DE)
(74) Vertreter: Siemens Patent Attorneys

(57) **Zusammenfassung**

Gegenstand der vorliegenden Erfindung ist ein Verfahren für eine Erkennung von fehlerhaften Messwerten eines elektrischen Energieverteilungsnetzes,
bei dem mittels Messeinrichtungen, die jeweils einen Messort zugeordnet sind, aktuelle Messwerte erfasst werden,
dadurch gekennzeichnet, dass
mittels einer Fehlererkennungseinrichtung fehlerhafte Messwerte in der Menge der aktuellen Messwerte ermittelt werden, so dass die fehlerhaften Messwerte bei einer weiteren Verarbeitung der aktuellen Messwerte für eine Zustandsschätzung des elektrischen Energieverteilungsnetzes unberücksichtigt bleiben.

Ferner sind eine entsprechende Fehlererkennungsanordnung und ein Computerprogrammprodukt Gegenstände der Erfindung.

## Beschreibung

Die Erfindung betrifft ein Verfahren für eine Erkennung von fehlerhaften Messwerten eines elektrischen Energieverteilungsnetzes gemäß dem Oberbegriff des Anspruchs 1, eine Fehlererkennungsanordnung gemäß dem Oberbegriff des Anspruchs 12 und ein Computerprogrammprodukt gemäß Anspruch 15.

Verteilnetzbetreiber haben bisher im Schnitt ca. 20% der Verteilnetzknoten mit Messeinrichtungen zur Messung elektrischer Größen ausgerüstet. Der Rest des Verteilnetzes ist unbeobachtet. Messwerte (z.B. analoge Messwerte und Schaltstellungen von Stufenstellern einstellbarer Ortsnetztransformatoren) können verzögert eintreffen. Es können auch Verfälschungen der Messwerte aufgrund einer Fehlkonfiguration des Messgerätes, durch Messgerätefehler, durch Übertragungsfehler bei der Datenübertragung an die Leitstelle oder durch gezielte Angriffe seitens Cyberkrimineller auftreten.

Die Erkennung der fehlerhaften Messwerte ist jedoch z.B. eine Voraussetzung für die erfolgreiche Zustandsschätzung des Netzes in der Leitstelle. Auch wenn der Kunde keine Zustandsschätzung durchführt, sondern nur z.B. ein Informationssystem in der Leitstelle nutzt, wird ihm die Information über die Korrektheit des Messwertes behilflich sein bei der Beurteilung der Notwendigkeit der Einleitung etwaiger Maßnahmen zur Netzstabilisierung oder zur Bekämpfung von Manipulationen, die beispielsweise durch das Einspielen von fehlerhaften Messwerten durch Saboteure oder Kriminelle auftreten können.

Aus der Produktbroschüre "Intelligent control center technology - Spectrum Power", Siemens AG 2017, Article-No. EMDG-B90019-00-7600, ist eine Software für ein sog. "Supervisory Control and Data Acquisition (SCADA)" System, also eine Leitstelle, bekannt. SCADA Systeme sind zur Kontrolle und Steuerung von Energienetzen lange bekannt (Wikipedia permananter link: https://en.wikipedia.org/w/index.php?title=SCADA&oldid=858433181). Dabei werden Messwerte von Sensoren, beispielsweise von Spannungsmessgeräten und Strommessgeräten im Energienetz, aggregiert und zur Leitstelle übermittelt. Zur Steuerung von Leistungsschaltern und Trennschaltern im Energienetz sowie zur Ansteuerung von Energieerzeugern wie Kraftwerken werden Steuerbefehle ins Energienetz gesendet. Diese Steuerbefehle werden von "Remote Terminal Units" (RTUs), "programmable logic controllers" (PLCs) und "intelligent electronic devices" (IEDs) empfangen und verarbeitet, um die Leistungsschalter und die Trennschalter usw. anzusteuern. In der Leitstelle ist bisher häufig ein lokales Rechenzentrum vorgesehen, auf dem die Leitstellensoftware wie z.B. "Sprectrum Power" läuft. Es werden rund um die Uhr Techniker in der Leitstelle bereitgehalten, die die Anzeigen des SCADA über den aktuellen Betriebszustand des Energienetzes kontrollieren und im Fehlerfall Gegenmaßnahmen wie z.B. die Abschaltung eines Netzabschnitts durchführen können. Die Leitstellensoftware wird in der Regel in einer zentralen Rechneranordnung betrieben, die beispielsweise als ein Rechenzentrum mit Prozessoren, Datenspeichern und Bildschirmen ausgebildet sein kann. Der Begriff "zentral" zielt dabei darauf ab, dass alle Messdaten aus dem Energienetz und alle Steuerbefehle für das Energienetz zentral verarbeitet werden.

Auch eine teilweise oder vollständige Ausbildung der Rechner-Anordnung bzw. der Leitstellensoftware als eine Cloud-Applikation, also eine Serveranordnung mit dezentral verteilten Ressourcen zur Datenverarbeitung und Datenspeicherung, die über ein Datennetzwerk wie z.B. das Internet verbunden sind, kann vorgenommen werden.

Als Begleiterscheinung einer immer weiteren Verbreitung von verteilter Energieerzeugung, also beispielsweise durch Photovoltaik-Anlagen oder Windkraftanlagen, wird durch die immer zahlreicheren lokalen Energieerzeuger, die in das Nieder- und Mittelspannungsnetz einspeisen, eine Vorhersage eines Systemzustands des Energienetzes erschwert. Auch die Abhängigkeit von Wettereinflüssen steigt, weil z.B. Solarzellen stark von der Bewölkung und Windkraftanlagen von der Windstärke beeinflusst werden. Diese Probleme wirken auch auf die nächsthöhere Spannungsebene eines Energieübertragungsnetzes der Hochspannungsebene zurück, das hierdurch schwieriger zu steuern und vorherzusagen ist.

Bisher werden in der Regel Last- und Erzeugungsprognosen und/oder Fahrpläne in Verbindung mit einem sog. "Distribution System Power Flow (DSPF)" eingesetzt, um einen zukünftigen Netzzustand abzuschätzen. Dabei verwendet DSPF statische Betriebsmitteldaten, lokale Vorhersagen für einen Energieverbrauch und eine Energieerzeugung sowie dynamische Topologie-Informationen (d.h. welche Leitungen zwischen den einzelnen Komponenten aktuell geschaltet sind), um einen prognostizierten Spannungsbetrag und Spannungswinkel an jedem Netzwerkabschnitt zu berechnen. Ein solcher Ansatz ist beispielsweise aus der Produktbroschüre "Spectrum Power Aktives Netzwerkmangement", Siemens AG 2016, EMFG-B10104-00, bekannt. Die technischen Grundlagen sind aus den Veröffentlichungen "Real-Time Distribution System State Estimation" von Dzafic et al., 2010 IEEE 978-I-4244-7398-4 und "Real-Time Estimation of Loads in Radial and Unsymmetrical Three-Phase Distribution Networks" von Dzafic et al., 2013 IEE 0885-8950, bekannt.

Derzeit messen Verteilnetzbetreiber im Schnitt ca. 20% der Verteilnetzknoten. Der Rest des Verteilnetzes ist unbeobachtet. Im Niederspannungsbereich werden vermehrt sog. "Smart Meter" eingesetzt, sie werden jedoch nicht wie die in Leitstellen empfangenen Messwerte in Echtzeit bereitgestellt, sondern treffen mehrere Stunden nach der Messung ein. Sie sind also für die Berechnung des Netzzustandes im Mittelspannungsbereich ohne weitere Verarbeitung wie z.B. in Vorhersagen nicht brauchbar.

Trotz allem wollen die Verteilnetzbetreiber unterrichtet werden, wenn auch an den unbeobachteten Knoten Grenzwertverletzungen auftreten. Oder wenn die wenigen verfügbaren Messwerte Inkonsistenzen zueinander aufweisen. Für diesen Zweck wird die Zustandsschätzung eingesetzt.

Klassische Verfahren für Zustandsschätzung aus dem Bereich der Übertragungsnetze sind in Verteilnetzen schwer anwendbar auf Grund der fehlenden gemessenen Information an im Schnitt 80% der Netzknoten. Daher werden häufig klassische Verfahren mit sog. Pseudomesswerten verwendet, mit deren Hilfe die Lastinformation modelliert wird. Diese Modelle sind jedoch sehr ungenau und erfordern meist weitere Verfahren wie z.B. eine Lastenskalierung, um die Lastinformation mit den gemessenen Werten zu initialisieren. Insbesondere dieses Verfahren erfordert viele Fallunterscheidungen (abhängig von verfügbaren Messwerten, deren Platzierung im Netz und Verfügbarkeit von verteilter Erzeugung) und ist an sich nicht sehr genau. Von der Genauigkeit der Lastenskalierung hängt jedoch das Konvergenzverhalten und die Treffsicherheit der Zustandsschätzung an den Messstellen ab.

Zusätzlich können die Skalierungsfaktoren genutzt werden, um falsche Messwerte zu identifizieren. Dabei werden Bereiche im Netz identifiziert, die von Messstellen umgeben sind. Die Lasten sind unbekannt. Anhand der Messwerte werden nun die Lasten berechnet, so dass die Lasten zu den gemessenen Werten passen. Wird beispielsweise eine zehnmal so hohe Last wie üblicherweise zu erwarten bestimmt (Skalierungsfaktor 10), so passen die erwartete Last und die Messwerte nicht zusammen und die Messwerte können als fehlerhaft ausgeschlossen werden. Wird beispielsweise ein negativer Skalierungsfaktor bestimmt (Energieerzeuger wird festgestellt anstatt wie erwartet eine Last zu finden), so spricht dies ebenfalls für fehlerhafte Messwerte.

Zusätzlich erfordern klassische Zustandsschätzungsverfahren sowie "Distribution System State Estimation" (DSSE) die Lösung eines unterbestimmten Gleichungssystems mittels Newton Raphson. Bei ungeeigneter Gewichtung der Messwerte oder Abhängig von der Wahl der Zustandsvariablen (Spannungen, Ströme oder Leistungen) kann es zu Konvergenzproblemen bei der Lösungsberechnung kommen. Auch Loop-Topologie scheint eine Herausforderung für diese Verfahren zu sein, wenn nicht Spannungen als Zustandsvariablen gewählt sind.

Neben den analytischen Verfahren kommen in letzter Zeit auch neuronale Netze (insbesondere "Multi Layer Perceptron Networks") zur Anwendung. Die größten Nachteile der neuronalen Netze sind jedoch:
- Starre Struktur (fixe Anzahl von Inputs und Outputs): Für jede Konfiguration von Messwerten und Schalterstellungen ist ein neuronales Netz erforderlich.
- Trainingsdaten müssen für jedes einzelne neuronale Netz bereitgestellt werden, das eine bestimmte Konfiguration aus Messwerten und Schalterstellungen repräsentiert.
- Training muss ausgeführt werden für jedes einzelne neuronale Netz.
- Neuronale Netze müssen gespeichert und verwaltet werden.
- Neuronale Netze müssen neu trainiert werden, wenn die Fehlerrate zu groß wird.

Beide Verfahren zeigen wegen der geringen Anzahl der Messwerte im Vergleich zu der Anzahl der Netzknoten (Verhältnis 20% - 80%) häufig wenig Erfolg in Verteilnetzen. Diese geringe Beobachtbarkeit hat häufig zur
Folge, dass falsche Messwerte als solche nicht erkannt werden bzw. richtige Messwerte als falsch klassifiziert
werden.

Aus der Veröffentlichung "Detect Abnormal SCADA Data Using State Estimation Residuals" von Jian Ma et al., IEEE 2010, ist ein Verfahren bekannt, um manipulierte SCADA-Daten zu erkennen. Ferner befasst sich die Veröffentlichung "Correlation-based Bad Data Detection of PMU Measurements for Improving Network Structure with High Penetration of Renewable Energy" von Guangzeng You, Preprints of the 5th IEEE Conference on Energy Internet and Energy System Integration
October 22- October 25, 2021, mit der Erkennung von fehlerhaften PMU Daten im Rahmen Kontrolle eines Energienetzes.

Ausgehend von bekannten Verfahren für eine Erkennung von Messfehlern stellt sich an die Erfindung die Aufgabe, ein Verfahren anzugeben, mit dem vergleichsweise einfach, schnell und zuverlässig Messfehler eines elektrischen Energieverteilnetzes erkannt werden.

Die Erfindung löst diese Aufgabe durch ein Verfahren gemäß Anspruch 1.

Bei der Verwendung von historischen Daten, die alle denkbaren Messwerttypen eines SCADA Systems sowie von IOT Geräten wie Smart Metern umfassen können, werden als Input historische Daten für jeden Messwertpunkt, dessen Werte geprüft werden sollen, benötigt. Zusätzlich können Daten von andersartigen Sensoren berücksichtigt werden. Beispielsweise Wetterdaten: Temperatur, Sonneneinstrahlung, Windstärke und Richtung, Feuchtigkeit. Auch Kalenderdaten: Wochentag,

Uhrzeit, Werk- oder Ruhetag können verwendet werden. Für diesen Zweck können zusätzlich Nachbarmesswerte des betrachteten Messorts im Netz berücksichtigt werden. Es werden durch das Verfahren z.B. die die Daten, die am Besten zu dem geprüften Zeitpunkt passen, gefiltert. Dies umfasst z.B. Wetterbedingungen, Kalenderdaten und Messwerte. Die Filterung basiert z.B. auf gewichteter Euklidischer Distanz.

Aus den mittels der Filterung ausgewählten Daten wird z.B. mit einem Regressionsmodell oder einem Hidden-Markov-Modell eine Vorhersage eine Zeiteinheit in die Zukunft vorhergesagt (z.B. für die nächsten 15 Minuten).

Messwerte, die außerhalb eines zulässigen Intervalls liegen (Z-score-test), werden als falsch identifiziert. Beispielsweise kann das Intervall als +/- 2σ festgelegt werden. Dabei steht σ für die empirische Standardabweichung.

Das Verfahren für allgemeine Messwerte und IOT Messwerte basiert auf der Verfügbarkeit von historischen Daten sowie der Verfügbarkeit von zusätzlichen Sensordaten (Wetter, Nachbarmesswerte). Diese erlauben die Varianz in der
Datenverteilung zu reduzieren, um eine triviale Prognose (einen Zeitschritt von z.B. 15 min in die Zukunft) und somit die Fehlererkennung durchzuführen.

Messfehler bzw. fehlerhafte Messwerte im Sinne der Erfindung sind beispielsweise mittels Messeinrichtungen gemessene elektrische Parameter an einem Messort wie z.B. einem Knotenpunkt eines elektrischen Energieverteilungsnetzes. Es kann sich z.B. um elektrische Leistung, elektrische Blindleistung, elektrische Spannung oder elektrische Stromstärke handeln.

Messeinrichtungen können beispielsweise Spannungsmessgeräte, Strommessgeräte, Phasenmessgeräte bzw. "Phasor measurement units (PMUs)", "Remote Terminal Units" oder Intelligente Stromzähler bzw. "Smart Meter", "Intelligent electrical devices (IEDs)" zur Überwachung von Schaltern und anderen Betriebsmitteln, Steuereinrichtungen z.B. für Intelligente Substations oder Schutzgeräte sein, die an den Messorten eingesetzt werden. Es kann sich prinzipiell um jede Art von IOT Gerät handeln. Die Datenübertragung der Messdaten kann dabei z.B. nach dem IEC 61850 Protokoll oder nach dem Internet-Protokoll erfolgen. Es können per Powerline-Communication über das Stromnetz, oder per Funk z.B. per LTE (4G) oder per Kabel wie z.B. Ethernet oder Lichtwellenleiter Daten übertragen werden.

Ein Zustand ist z.B. eine Gesamtmenge von Werten elektrischer Größen, die an verschiedenen Punkten in dem Energieverteilnetz zu einem vorgegebenen Zeitpunkt vorliegen. Beispielsweise umfasst der Zustand die Spannungen, die an den Punkten vorliegen. Die Punkte bzw. Messpunkte können z.B. Knotenpunkte sein, d.h. Endpunkte einer Leitung oder eine Leitungskreuzung. Typischerweise werden an solchen Knotenpunkten auch Messorte für Messeinrichtungen für elektrische Spannung, Stromstärke und ggf. Phasenwinkel vorgesehen. Eine Zustandsschätzung ist eine mit einem Computer berechnete Schätzung des Zustands, basierend auf verfügbaren Messwerten, d.h. das für diejenigen Knoten, die nicht mit Messgeräten beobachtet werden können, der Zustand bzw. die elektrischen Größen berechnet werden.

Ein Netzzustand bzw. eine Zustandsschätzung im Sinne der Erfindung umfasst beispielsweise eine Angabe über den Spannungsbetrag bzw. eine elektrische Spannung und den Spannungswinkel bzw. Phasenwinkel an jedem Netzwerkabschnitt. Ein Netzwerkabschnitt wird z.B. auch als "network bus" im Sinne des "bus-branch"-Modells bezeichnet. Er fungiert als ein Netzmodell-Verbindungspunkt, an dem modellierte Betriebsmittel des elektrischen Netzes wie Leitungen, Transformatoren, Verbraucher und Erzeuger elektrischer Energie verknüpft sein können.

Eine Einrichtung im Sinne der Erfindung weist beispielsweise Prozessoren, Datenspeicher und Bildschirme auf. Einrichtungen sind z.B. Computer wie z.B. Server, die
Datenprozessorressourcen und Datenspeicherressourcen aufweisen und Daten mit anderen Computern austauschen können. Es kann sich auch um Softwaremodule handeln, die auf einer Cloud-Infrastruktur ausgeführt werden, d.h. eine räumlich verteilte Server- und Datenbankarchitektur.

In einer bevorzugten Ausführungsform des erfindungsgemäßen Verfahrens werden aus einer Messwertedatenbank historische Messdaten für jeden Messort ausgewählt, deren Ähnlichkeit nach einem Ähnlichkeitsmaß in Bezug auf mindestens einen beeinflussenden Faktor einen Ähnlichkeitsschwellenwert überschreitet, und es wird anhand der ausgewählten historischen Messdaten anhand eines mathematischen Modells ein Vorhersagewert für jeden aktuellen Messwert gebildet, und es wird ein aktueller Messwert jeweils als ein fehlerhafter Messwert erkannt, wenn der aktuelle Messwert mehr als ein vorher festgelegtes Fehlermaß von dem Vorhersagewert abweicht. Das vorher festgelegte Fehlermaß kann beispielsweise +/- 2 σ betragen (d.h. zweimal die empirische Standardabweichung).

In einer weiteren bevorzugten Ausführungsform des erfindungsgemäßen Verfahrens weist der mindestens eine beeinflussende Faktor mindestens einen der folgenden Faktoren auf: Temperatur am Messort, Sonneneinstrahlung am Messort, Windstärke und Windrichtung am Messort, Luftfeuchtigkeit und/oder Niederschlag am Messort, Kalenderdaten, Wochentag, Uhrzeit, Werktag, Wochenendetag, Feiertag. Dies ist ein Vorteil, weil historische Messwerte ausgewählt werden, die bei vergleichbaren Netzzuständen (z.B. Sonnenschein und kein Wind an einem Sonntagnachmittag) aufgenommen wurden. Dies ermöglicht eine passgenaue Ermittlung von Vergleichsdaten.

In einer weiteren bevorzugten Ausführungsform des erfindungsgemäßen Verfahrens wird für das Ähnlichkeitsmaß eine gewichtete euklidische Distanz berücksichtigt. Dies ist ein Vorteil, weil dieser Ansatz besonders einfach ist. Eine Gewichtung kann beispielsweise die Sonneneinstrahlung höher gewichten als die Windstärke. Insbesondere kann die Gewichtung darauf abgestimmt werden, welche Energieerzeuger und/oder Verbraucher am jeweiligen Messort besonders stark von dem beeinflussenden Faktor beeinflusst werden. Sind am Messort beispielsweise Photovoltaikanlagen angeschlossen, aber keine Windkraftanlage, so kann die Sonneneinstrahlung viel höher als die Windstärke berücksichtigt werden bei der Auswahl der historischen Daten. In Bezug auf die Verbraucher kann beispielsweise am Wochenende mittags wegen Zubereitung des Mittagessens der Wochentag besonders stark gewichtet werden, wenn am Messort Lasten wie Privathaushalte überwiegen.

In einer weiteren bevorzugten Ausführungsform des erfindungsgemäßen Verfahrens wird als Ähnlichkeitsmaß ein Regressionsmodell verwendet. Dies ist ein Vorteil, weil dieser Ansatz besonders einfach ist.

In einer weiteren bevorzugten Ausführungsform des erfindungsgemäßen Verfahrens wird für das Ähnlichkeitsmaß ein Hidden-Markov-Modell verwendet. Dies ist ein Vorteil, weil dieser Ansatz vergleichsweise genau ist. Ein Hidden-Markov-Modell ist ein mathematisches Modell, das beispielsweise von Wikipedia bekannt ist (permanenter Link:
https://de.wikipedia.org/w/index.php?title=Hidden_Markov_Model&oldid=224921402). Dabei wird davon ausgegangen, dass unbeobachtete Zustände ineinander übergehen können, wobei die Übergänge jedoch nicht direkt beobachtet werden können, sondern lediglich Ausgaben bzw. Emissionen des modellierten Systems. Bezogen auf die vorliegende Modellierung sind die unbeobachteten Zustände die an den Knotenpunkten tatsächlich vorliegenden Werte von elektrischen Größen, d.h. die Vorhersagewerte.

Das Verfahren basiert dabei z.B. auf der Verwendung von finiten Hidden- Markov-Modellen. Es ist daher der Gruppe der Verfahren aus dem Bereich des maschinellen Lernens zuzuordnen. Anders als klassische Zustandsschätzungsverfahren aus dem Übertragungsnetzbereich braucht es nur eine grobe Spezifikation der Last und zeigt keine Sensitivität bezüglich der verfügbaren Messwerttypen im elektrischen Netz. Auch die Wahl der Zustandsvariablen hat keinen Einfluss auf die Stabilität der Lösungsfindung. Es gibt keine Konvergenzprobleme. Im Gegensatz zu neuronalen Netzen erfordert es kein Training und es muss auch nicht für jede Messwertkonstellation und Schalterstellung ein separates Modell abspeichert und trainiert werden. Vielmehr werden nur Trainingsdaten abgespeichert, keine Modelle.

In einer weiteren bevorzugten Ausführungsform des erfindungsgemäßen Verfahrens wird mittels einer Lastflussberechnungseinrichtung anhand eines Netzmodells, das Knotenpunkte und Schalteinrichtungen und Messsorte berücksichtigt, für eine Vielzahl von Lastzuständen und für eine Vielzahl von Schaltzuständen der Schalteinrichtungen Lastflussberechnungen durchgeführt und das jeweilige Lastflussergebnis in einem Lastflussdatensatz gespeichert, wobei der Lastflussdatensatz für jeden Knotenpunkt im Netzmodell eine Wahrscheinlichkeitsverteilung für jeweils einen Vorhersagewert bereitstellt, und es wird mittels der Fehlererkennungseinrichtung unter Berücksichtigung des Lastflussdatensatzes und aktueller Schaltzustände von Schalteinrichtungen jeweils eine Gaußverteilung für jeden Messort bestimmt, um einen wahrscheinlichsten Wert für einen jeweiligen Vorhersagewert für jeden Messort zu bestimmen, und es wird
ein aktueller Messwert jeweils als ein fehlerhafter Messwert erkannt, wenn der aktuelle Messwert mehr als ein vorher festgelegtes Fehlermaß von dem Vorhersagewert abweicht.

Bei der Verwendung von Lastflussergebnissen nutzt das Verfahren ein Netzmodell und eine verfügbare Lastflussapplikation, welche i.d.R. in einer Leitstellensoftware bereits vorhanden ist. Es erwartet weiterhin nur sehr grobe Informationen über die Lasten (Lastenverteilungen) als Input. Das Verfahren betrachtet das elektrische Netz als eine wohl definierte Größe und basiert auf einer Verfügbarkeit von Trainingsdaten (z.B. erzeugt per Monte-Carlo-Simulation), die mittels Lastflussberechnungen in den Bereichen der Lastflusskonvergenz (Trainingsdaten, bei denen kein Lastfluss korrekt berechnet werden kann, werden verworfen) erzeugt werden. Die im Verlauf der Trainingsdatenerzeugung berechneten Werte an den Messstellen passen daher perfekt zu dem Netz und spiegeln zuverlässig Messwertfehler wider.

Ferner filtert das Verfahren die Daten, die zu den gültigen SCADA Messwerten für einen bestimmten Zeitpunkt und zu einem Netzsubsystem am Besten passen. Die Filterung basiert auf gewichteter Euklidischer Distanz. Für jeden fehlerhaften Messort und Zeitpunkt wird bevorzugt eine unimodale Gaußverteilung erzeugt. Werte mit der größten Wahrscheinlichkeit (um den Mittelpunkt) werden zusammen mit der Wahrscheinlichkeit zurückgegeben.

Ferner inkorporiert das Verfahren z.B. eine einfache gewichtete Datenfilterung, um Szenarien aus dem Lastflussdatensatz bzw. einer Datenbank mit dem Lastflussdatensatz auszuwählen, in denen der Messwertpfad sehr ähnlich war. Zuletzt werden unimodale Verteilungen für jeden fehlerhaften Messwert erzeugt und die Positionierung des Messwertes innerhalb der Verteilung geprüft. Liegt der Messwert außerhalb des zulässigen Intervalls, wird er als falsch erkannt. Das Verfahren für die Korrektur der SCADA Messwerte basiert auf Verfügbarkeit von Trainingsdaten, die wie eingangs erläutert mittels Lastflussberechnung und Variationen einer Netzbelastung durch Verbraucher elektrischer Energie innerhalb der Grenzen der Lastflusskonvergenz leicht erzeugbar sind.

Ein Netzmodell ist z.B. eine Beschreibung der Topologie, d.h. der räumlichen Anordnung von Betriebsmitteln wie Schalteinrichtungen, Transformatoren, Verbrauchern bzw. Lasten usw. sowie Leitungen. Beispielsweise enthält das Netzmodell Informationen über die räumliche Anordnung von Knotenpunkten, Schalteinrichtungen und Messsorten.

Ein Lastzustand gibt beispielsweise für jeden Knotenpunkt an, ob die angeschlossenen Lasten / Verbraucher mit einem Faktor zwischen 0 und 1, bezogen auf die durch die Bauart der angeschlossenen Verbraucher vorgegebene Maximallast, elektrische Energie verbrauchen.

Die Schaltzustände sind beispielsweise ein offener oder ein geschlossener Zustand für jede Schalteinrichtung.

Das Lastflussergebnis wird für das jeweils zu berechnende Beispiel, d.h. den angenommenen Lastzustand, auf an sich übliche Weise mit einem Lastflussalgorithmus berechnet. Dabei kann mit einem Zufallsgenerator eine große Anzahl, z.B. über 100, noch mehr bevorzugt über 1000, unterschiedliche Kombinationen von Lastzuständen und Schaltzuständen simuliert werden.

Der Lastflussdatensatz wird z.B. in einem Datenspeicher eines Computers, oder in einer Cloud-Datenspeicherlösung, abgelegt. Er muss i.d.R. nur einmal vorab berechnet werden und umfasst beispielsweise einige hundert oder einige tausend Lastflussergebnisse, die sich aus unterschiedlichen Last- und Schaltzuständen ergeben. Eine Aktualisierung kann durchgeführt werden, wenn durch Neuinstallationen von Geräten, Ausbau des Netzes mit neuen Leitungen, usw. die Topologie des Energieverteilnetzes verändert wird.

In Abhängigkeit von der Vielzahl der Lastflussergebnisse kann die
Wahrscheinlichkeitsverteilung eines Vorhersagewerts, z.B. Spannung, berechnet werden für jeden Knoten. Es kann z.B. eine gaußsche Normalverteilung angenommen werden, deren Mittelwert dem wahrscheinlichsten Fall entspricht. Mit anderen Worten ergibt sich z.B. für jeden Knoten ein wahrscheinlichster Spannungswert, der als Erwartungswert über die Vielzahl von Last- und Schaltzuständen dient.

Das Verfahren nutzt ein Netzmodell und eine oft in Leitstellensystemen schon verfügbare Lastflussapplikation, welche in diesem Kontext ohne weiteres eingesetzt werden kann. Es erwartet weiterhin nur sehr grobe Informationen über die Lasten (Lastenverteilungen).

In einer weiteren bevorzugten Ausführungsform des erfindungsgemäßen Verfahrens wird mittels einer ersten Auswahleinrichtung aus dem Lastflussdatensatz eine Untergruppe von Lastflussergebnissen ausgewählt und für die Zustandsschätzungseinrichtung bereitgestellt, wobei anhand eines Ähnlichkeitsmaßes die Ähnlichkeit von an Messorten gemessenen aktuellen Messwerten zu den Wahrscheinlichkeitsverteilungen ermittelt wird, und bei Überschreitung eines Schwellenwertes für die Ähnlichkeit das jeweilige Lastflussergebnis ausgewählt wird. Dies ein Vorteil, weil durch die zuvor durchgeführte Fehlererkennung und die geschickte Auswahl der vorher simulierten Lastflussfälle basierend auf korrekten Messwerten eine besonders zuverlässige Fehlerkorrektur möglich wird. Die Untergruppe umfasst bevorzugt mehr als 5, noch mehr bevorzugt mehr 35 Lastflussergebnisse.

In einer weiteren bevorzugten Ausführungsform des erfindungsgemäßen Verfahrens werden mittels einer zweiten Auswahleinrichtung aus dem Lastflussdatendatz Lastflussergebnisse ausgewählt und für die Zustandsschätzungseinrichtung bereitgestellt, deren zugrundeliegende Schaltzustände mit den aktuellen Schaltzuständen übereinstimmen.

In einer weiteren bevorzugten Ausführungsform des erfindungsgemäßen Verfahrens wird mittels der Fehlererkennungseinrichtung die Ermittlung fehlerhafter Messwerte in regelmäßigen Zeitstabständen wiederholt. Dies ist ein Vorteil, weil z.B. jeweils vor einer Zustandsschätzung durch eine Leitstellensoftware für das Energieverteilungsnetz überprüft werden kann, ob in der Menge der aktuellen Messwerte fehlerwerte Messwerte enthalten sind, die eine Zustandsschätzung ungenauer machen würden. Beispielsweise kann die Fehlererkennung alle 15 min wiederholt werden. Bevorzugt wird die Fehlererkennung mehrfach pro Stunde wiederholt.

In einer weiteren bevorzugten Ausführungsform des erfindungsgemäßen Verfahrens wird für das elektrische Energieverteilungsnetz ein Mittelspannungsnetz mit einer Nennspannung von 1 kV bis 52 kV verwendet.

In einer weiteren bevorzugten Ausführungsform des erfindungsgemäßen Verfahrens wird für das elektrische Energieverteilungsnetz ein Niederspannungsnetz mit einer Nennspannung von höchstens 1 kV verwendet wird. Auch für Niederspannungsnetze können mittlerweile ausreichend genaue Topologieinformationen bereitgestellt werden.

In einer weiteren bevorzugten Ausführungsform des erfindungsgemäßen Verfahrens wird bei Erkennung eines fehlerhaften Messwerts der Messwert durch den wahrscheinlichsten Wert ersetzt. Dies ist ein Vorteil, weil mit diesem Ansatz eine automatisierte Korrektur der Messwerte ermöglicht wird. Die Korrektur fehlerhafter Messwerte basiert folglich auf Lastflussergebnissen (SCADA Messwerten). Das Verfahren erwartet ein Netzmodell und eine verfügbare Lastflussapplikation, welche in diesem Kontext ohne weiteres verfügbar gemacht werden können. Es erwartet weiterhin nur sehr grobe Informationen über die Lasten in Form von Verteilungen. Das Verfahren betrachtet das elektrische Netz als eine wohl definierte Größe und basiert auf Verfügbarkeit von Trainingsdaten, die mittels Lastfluss in den Bereichen der Lastflusskonvergenz erzeugt werden. Die im Verlauf der Trainingsdatenerzeugung berechneten Werte an den Messstellen passen perfekt zu dem Netz und spiegeln daher zuverlässig Messwertfehler wider. Ferner filtert das Verfahren die Daten, die am Besten zu den gültigen SCADA Messwerten für einen definierten Zeitpunkt und ein Netzsubsystem passend sind. Die Filterung basiert auf gewichteter Euklidischer Distanz. Für jeden ungültigen Messwert wird eine unimodale Gaußverteilung erzeugt und der Wert mit der höchsten Wahrscheinlichkeit (Mittelwert) zurückgegeben, um einen fehlerhaften Messwert zu korrigieren.

Ausgehend von bekannten Anordnungen für eine Zustandsschätzung stellt sich ferner an die Erfindung die Aufgabe, eine Zustandsschätzungsanordnung anzugeben, mit der vergleichsweise einfach, schnell und zuverlässig der Zustand eines elektrischen Energieverteilnetzes geschätzt werden kann.

Die Erfindung löst diese Aufgabe durch eine Fehlererkennungsanordnung nach Anspruch 12. Bevorzugte Ausführungsformen sind in den Ansprüchen 13 und 14 beschrieben. Es ergeben sich sinngemäß die gleichen Vorteile wie eingangs für das erfindungsgemäße Verfahren erläutert.

Ausgehend von bekannten Computerprogrammprodukten für eine Fehlererkennung stellt sich ferner an die Erfindung die Aufgabe, ein Computerprogrammprodukt anzugeben, mit dem vergleichsweise einfach, schnell und zuverlässig fehlerhafte Messwerte eines elektrischen Energieverteilnetzes erkannt werden können.

Die Erfindung löst diese Aufgabe durch ein Computerprogrammprodukt nach Anspruch 15. Es ergeben sich sinngemäß die gleichen Vorteile wie eingangs für das erfindungsgemäße Verfahren erläutert.

Zur besseren Erläuterung der Erfindung zeigen in schematischer Darstellung die
Figur 1 die Verfahrensschritte zur Datenvorbereitung, und
Figur 2 die Verfahrensschritte zur Fehlererkennung, und

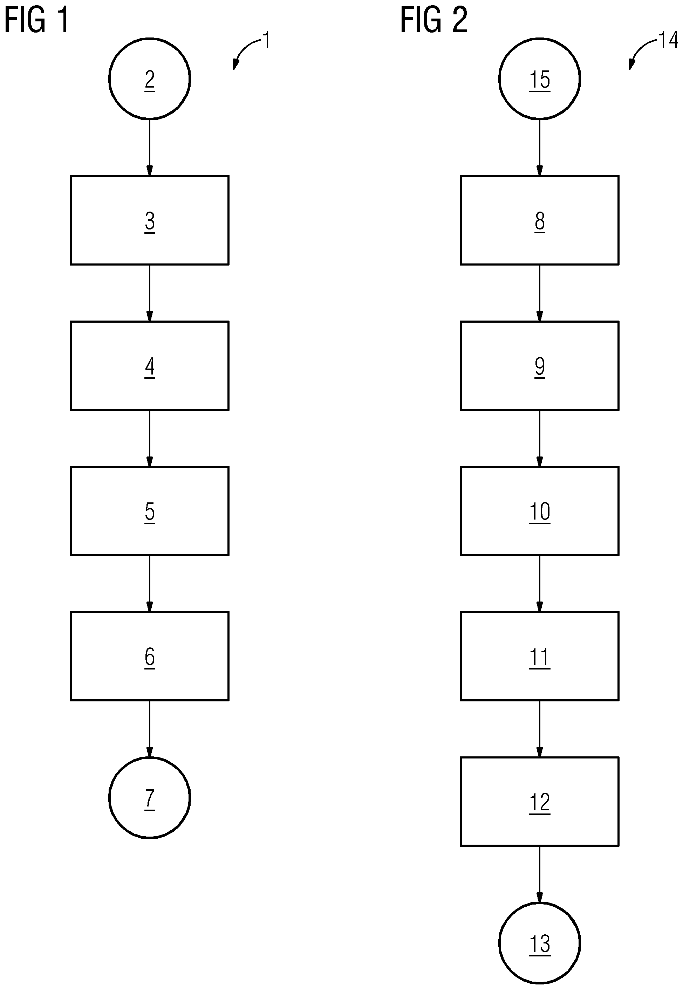

Die Figur 1 zeigt die Verfahrensschritte zur Datenvorbereitung 1.

Die Datenvorbereitung 1 wird entkoppelt von Fehlererkennung durchgeführt, deren Ergebnisse werden in einer Datenbank bereitgestellt werden.

Nach dem Start 2 wird ein elektrisches Netzmodell im Schritt 3 bereitgestellt, das Schalter beinhaltet. Im Schritt 4 wird eine grob aufgelöste Lastinformation bereitgestellt, d.h. welche Lasten an den einzelnen Netzknoten gemäß dem Netzmodell vorliegen könnten. Im Schritt 5 werden anhand eines Netzmodells für eine Vielzahl von Lastzuständen und für eine Vielzahl von Schaltzuständen von Schalteinrichtungen Lastflussberechnungen durchgeführt und das jeweilige Lastflussergebnis wird in Schritt 6 in einem Lastflussdatensatz gespeichert. Das Lastflussergebnis kann z.B. für jeden Knoten einen oder mehrere der folgenden Werte beinhalten: Strom, Spannung, Leitung, Blindleistung. Damit ist die Datenvorbereitung 1 im Schritt 7 abgeschlossen.

Bei der eigentlichen Zustandsschätzung 14 wird nach dem Start 15 eine Topologieinformation über das Energienetz bereitgestellt. Die Topologieinformation enthält beispielsweise Angaben über Leitungen und Verzweigungen des Netzes, d.h. über Knotenpunkte im Energienetz. Ferner sind Messorte von Messstellen, die in der Regel einem Knotenpunkt räumlich zugeordnet sind, enthalten. Auch werden Schalteinrichtungen berücksichtigt. Mit den Schalterstellungen (z.B. eingeschaltet oder ausgeschaltet) gestattet die Topologieinformation es, Lastflüsse im Netz zu berechnen. Ferner wird ein Messpfad bereitgestellt, entlang dessen ein Lastfluss betrachtet wird.

Im nächsten Schritt 9 wird im Lastflussdatensatz ein Lastflussergebnis mit dergleichen (oder sehr ähnlicher) Topologie ausgewählt, d.h. dass insbesondere die Schalteinrichtungen die vergleichbare Schaltstellungen aufweisen. Hier wird also aus der Datenvorbereitung 1 ein Zwischenergebnis abgefragt, was besonders einfach und schnell erfolgen kann. Ferner sollte das ausgewählte Lastflussergebnis den ähnlichsten Messpfad im Vergleich zu dem im Schritt 8 gewählten Messpfad aufweisen.

Im Schritt 10 wird für jeden Messort zum gewählten Zeitpunkt ein Vorhersagewert bestimmt. Es kommt eine unimodale Gaussverteilung zum Einsatz.

Im Schritt 11 wird ein sogenannter "z-score test" genutzt, um eine Abweichung nach dem Fehlermaß der empirischen Standardabweichung zu bestimmen.

Im Schritt 12 werden als fehlerhaft erkannte Messwerte bereitgestellt, so dass diese bei der weiteren Verarbeitung der aktuellen Messwerte unberücksichtigt bleiben können.

Damit ist in Schritt 13 das Ende des Verfahrens erreicht.

## Patentansprüche

1. Verfahren für eine Erkennung von fehlerhaften Messwerten eines elektrischen Energieverteilungsnetzes,
bei dem mittels Messeinrichtungen, die jeweils einem Messort zugeordnet sind, aktuelle Messwerte erfasst werden,
**dadurch gekennzeichnet, dass**
mittels einer Fehlererkennungseinrichtung fehlerhafte Messwerte in der Menge der aktuellen Messwerte ermittelt werden, so dass die fehlerhaften Messwerte bei einer weiteren Verarbeitung der aktuellen Messwerte für eine Zustandsschätzung des elektrischen Energieverteilungsnetzes unberücksichtigt bleiben.

2. Verfahren nach Anspruch 1, **dadurch gekennzeichnet, dass** aus einer Messwertedatenbank historische Messdaten für jeden Messort ausgewählt werden, deren Ähnlichkeit nach einem Ähnlichkeitsmaß in Bezug auf mindestens einen beeinflussenden Faktor einen Ähnlichkeitsschwellenwert überschreitet, und anhand der
ausgewählten historischen Messdaten anhand eines mathematischen Modells ein Vorhersagewert für jeden aktuellen Messwert gebildet wird, und ein aktueller Messwert jeweils als ein fehlerhafter Messwert erkannt wird, wenn der aktuelle Messwert mehr als ein vorher festgelegtes Fehlermaß von dem Vorhersagewert abweicht.

3. Verfahren nach Anspruch 2, **dadurch gekennzeichnet, dass** der mindestens eine beeinflussende Faktor mindestens einen der folgenden Faktoren aufweist: Temperatur am Messort, Sonneneinstrahlung am Messort, Windstärke und Windrichtung am Messort, Luftfeuchtigkeit und/oder Niederschlag am Messort, Kalenderdaten, Wochentag, Uhrzeit, Werktag, Wochenendetag, Feiertag.

4. Verfahren nach Anspruch 2 oder 3, **dadurch gekennzeichnet, dass** für das Ähnlichkeitsmaß eine gewichtete euklidische Distanz berücksichtigt wird.

5. Verfahren nach Anspruch 4, **dadurch gekennzeichnet, dass** als Ähnlichkeitsmaß ein Regressionsmodell verwendet wird.

6. Verfahren nach Anspruch 4, **dadurch gekennzeichnet, dass** für das Ähnlichkeitsmaß ein Hidden-Markov-Modell verwendet wird.

7. Verfahren nach einem der vorhergehenden Ansprüche, **dadurch gekennzeichnet, dass** mittels einer Lastflussberechnungseinrichtung anhand eines Netzmodells, das Knotenpunkte und Schalteinrichtungen und Messsorte berücksichtigt, für eine Vielzahl von Lastzuständen und für eine Vielzahl von Schaltzuständen der Schalteinrichtungen Lastflussberechnungen durchgeführt und das jeweilige Lastflussergebnis in einem Lastflussdatensatz gespeichert wird, wobei der Lastflussdatensatz für jeden Knotenpunkt im Netzmodell eine Wahrscheinlichkeitsverteilung für jeweils einen Vorhersagewert bereitstellt, und dass mittels der Fehlererkennungseinrichtung unter Berücksichtigung des Lastflussdatensatzes und aktueller Schaltzustände von Schalteinrichtungen jeweils eine Gaußverteilung für jeden Messort bestimmt wird, um einen wahrscheinlichsten Wert für einen jeweiligen Vorhersagewert für jeden Messort zu bestimmen, und
ein aktueller Messwert jeweils als ein fehlerhafter Messwert erkannt wird, wenn der aktuelle Messwert mehr als ein vorher festgelegtes Fehlermaß von dem Vorhersagewert abweicht.

8. Verfahren nach Anspruch 7, **dadurch gekennzeichnet, dass** mittels einer ersten Auswahleinrichtung aus dem Lastflussdatendatz eine Untergruppe von Lastflussergebnissen ausgewählt und für die Zustandsschätzungseinrichtung bereitgestellt wird, wobei anhand eines Ähnlichkeitsmaßes die Ähnlichkeit von an Messorten gemessenen aktuellen Messwerten zu den Wahrscheinlichkeitsverteilungen ermittelt wird, und bei Überschreitung eines Schwellenwertes für die Ähnlichkeit das jeweilige Lastflussergebnis ausgewählt wird.

9. Verfahren nach einem der vorhergehenden Ansprüche, **dadurch gekennzeichnet, dass** mittels einer zweiten Auswahleinrichtung aus dem Lastflussdatendatz Lastflussergebnisse ausgewählt und für die Zustandsschätzungseinrichtung bereitgestellt werden, deren zugrundeliegende Schaltzustände mit den aktuellen Schaltzuständen übereinstimmen.

10. Verfahren nach einem der vorhergehenden Ansprüche, **dadurch gekennzeichnet, dass** mittels der Fehlererkennungseinrichtung die Ermittlung fehlerhafter Messwerte in regelmäßigen Zeitstabständen wiederholt wird.

11. Verfahren nach einem der Ansprüche 7 bis 9, **dadurch gekennzeichnet, dass** bei Erkennung eines fehlerhaften Messwerts der Messwert durch den wahrscheinlichsten Wert ersetzt wird.

12. Fehlererkennungsanordnung für eine Erkennung von fehlerhaften Messwerten eines elektrischen Energieverteilungsnetzes, aufweisend
Messeinrichtungen, die jeweils einen Messort zugeordnet sind, und zur Erfassung aktueller Messwerte ausgebildet sind,
**dadurch gekennzeichnet, dass**
eine Fehlererkennungseinrichtung ausgebildet ist, fehlerhafte Messwerte in der Menge der aktuellen Messwerte zu ermitteln, so dass die fehlerhaften Messwerte bei einer weiteren Verarbeitung der aktuellen Messwerte für eine Zustandsschätzung des elektrischen Energieverteilungsnetzes unberücksichtigt bleiben.

13. Fehlererkennungsanordnung nach Anspruch 12, **dadurch gekennzeichnet, dass** eine Auswahleinrichtung ausgebildet ist, historische Messdaten für jeden Messort aus einer Messwertedatenbank auszuwählen, deren Ähnlichkeit nach einem Ähnlichkeitsmaß in Bezug auf mindestens einen beeinflussenden Faktor einen Ähnlichkeitsschwellenwert überschreitet, und anhand der
ausgewählten historischen Messdaten anhand eines mathematischen Modells ein Vorhersagewert für jeden aktuellen Messwert zu bilden, wobei ein aktueller Messwert jeweils als ein fehlerhafter Messwert erkannt wird, wenn der aktuelle Messwert mehr als ein vorher festgelegtes Fehlermaß von dem Vorhersagewert abweicht.

14. Fehlererkennungsanordnung nach Anspruch 12 oder 13, **dadurch gekennzeichnet, dass** eine Lastflussberechnungseinrichtung ausgebildet ist, anhand eines Netzmodells, das Knotenpunkte und Schalteinrichtungen und Messsorte berücksichtigt, für eine Vielzahl von Lastzuständen und für eine Vielzahl von Schaltzuständen der Schalteinrichtungen Lastflussberechnungen durchzuführen und das jeweilige Lastflussergebnis in einem Lastflussdatensatz zu speichern, wobei der Lastflussdatensatz für jeden Knotenpunkt im Netzmodell eine Wahrscheinlichkeitsverteilung für jeweils einen Vorhersagewert bereitstellt, und dass
eine Fehlererkennungseinrichtung ausgebildet ist, unter Berücksichtigung des Lastflussdatensatzes und aktueller Schaltzustände von Schalteinrichtungen und aktueller Messwerte, die an den Messorten erfasst wurden, jeweils eine Gaußverteilung für jeden Messort zu bestimmen, um einen wahrscheinlichsten Wert für einen jeweiligen Vorhersagewert zu bestimmen, und
einen aktuellen Messwert jeweils als einen fehlerhaften Messwert zu erkennen, wenn der aktuelle Messwert mehr als ein vorher festgelegtes Fehlermaß von dem Vorhersagewert abweicht.

15. Computerprogrammprodukt, umfassend Befehle, die bei der Ausführung des Programms durch einen Computer diesen veranlassen, das Verfahren nach einem der Ansprüche 1 bis 11 auszuführen.
